## Europäisches Patentamt

## European Patent Office

## Office européen des brevets

(19)

(11) Veröffentlichungsnummer: **0 177 722**
**B1**

(12) **EUROPÄISCHE PATENTSCHRIFT**

(45) Veröffentlichungstag der Patentschrift:
09.08.89

(51) Int. Cl.⁴: **G01R 31/28**

(21) Anmeldenummer: 85110469.5

(22) Anmeldetag: 20.08.85

(54) Verfahren und Vorrichtung zur Lokalisierung von Schwachstellen im Innern einer elektrischen integrierten Schaltung.

(30) Priorität: 13.09.84 DE 3433659

(43) Veröffentlichungstag der Anmeldung:
16.04.86 Patentblatt 86/16

(45) Bekanntmachung des Hinweises auf die Patenterteilung:
09.08.89 Patentblatt 89/32

(84) Benannte Vertragsstaaten:
DE FR GB IT NL

(56) Entgegenhaltungen:
NEW ELECTRONICS, Band 15, Nr. 7, 6. April 1982,
Selten 66-69, London, GB; C.P. STRUDWICK: "Liquid
crystals map i.c.s."
MESURES - REGULATION - AUTOMATISME, Band 46,
Nr. 6/7, Juni/Juli 1981, Seiten 83-86, Paris, FR: "Deux
méthodes optiques de visulatisation du
fonctionnement interne des circuits intégrés"

(73) Patentinhaber: Siemens Aktiengesellschaft Berlin und
München, Wittelsbacherplatz 2, D-8000 München 2(DE)

(72) Erfinder: Schmid, Ralf, Spitalstrasse 10/I,
D-7463 Rosenfeld(DE)
Erfinder: Otto, Johann, Dipl.-Ing.,
Pater-Hammerschmid-Strasse 4, D-8170 Bad Tölz(DE)
Erfinder: Knapek, Erwin, Dr. Dipl.-Phys.,
Franz-Schubert-Strasse 26, D-8025 Unterhaching(DE)
Erfinder: Bernklau, Daniela, Erikastrasse 32,
D-8012 Riemerling(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein Verfahren und eine Vorrichtung zur Lokalisierung von Schwachstellen im Innern einer elektrischen integrierten Schaltung nach dem Oberbegriff des Anspruchs 1 bzw. nach dem Oberbegriff des Anspruchs 8.

Die Thermographie, d.h. die Messung von Temperaturverteilungen auf Oberflächen, gewinnt für die Entwicklung und Qualitätsanalyse von integrierten Schaltungen oder von sonstigen stromdurchflossenen elektrischen Bauteilen zunehmend an Bedeutung. Das zur Zeit empfindlichste Verfahren zur Bestimmung von "hot spots" (lokal begrenzten thermisch belasteten Bereichen) ist die Temperaturmessung mit Flüssigkristall-Schichten im Polarisationsmikroskop. Dabei sind Flüssigkristall-Schichten auf die zu untersuchenden Oberflächen aufgebracht. Das Studium der Doppelbrechung des Flüssigkristalls dient dabei im polarisierten Licht zur Ermittlung von Strukturen dieses Flüssigkristalls. Aus Strukturveränderungen der Flüssigkristall-Schicht auf der zu untersuchenden Oberfläche kann auf Temperaturunterschiede innerhalb der zu untersuchenden Oberfläche geschlossen werden. Aus den Temperaturunterschieden innerhalb der zu untersuchenden Oberfläche kann dann wiederum auf elektrische Eigenschaften innerhalb dieser Oberfläche geschlossen werden.

Wenn eine Flüssigkristall-Schicht auf die Oberfläche eines integrierten Schaltkreises aufgebracht worden ist, kann auch aus der Intensität der Reflexion eines Laserstrahles, die durch das System Flüssigkristall-Schicht/Oberfläche erfolgt, auf die elektrische Eigenschaft (Verlustleistung, Temperatur) derjenigen Stelle auf der Oberfläche geschlossen werden, auf die der Laserstrahl auftrifft.

Das Prinzip eines "hot spot"-Detektors ist in der WO-A 83/01 989 beschrieben. Es wird auch auf "New Electronics", Band 15, Nr. 7, 6. April 1982, Seiten 66–69 verwiesen.

Mit einem solchen bekannten Thermographie-Verfahren können nur heißeste Stellen detektiert werden. Eine Dosierung der Temperaturerhöhung zur Detektion unterschiedlich stark ausgeprägter Schwachstellen ist mit einem solchen bekannten Thermographie-Verfahren nicht möglich. Eine Lokalisierung von Leckstromkanälen ist daher mit einem solchen bekannten Thermographie-Verfahren praktisch nur in Ansätzen möglich.

Wie in jedem Lehrbuch für Raster-Elektronenmikroskopie beschrieben ist, kann mit Hilfe eines induzierten Probenstromes (EBIC: Electron Beam Induced Current) in einem Raster- Elektronenmikroskop ein pn-Übergang einer Halbleiterdiode abgebildet werden. Dabei dringen Primärelektronen mit einer Energie von beispielsweise 20 keV in die Halbleiterdiode ein. Diese Primärelektronen werden dabei gestreut und verlieren ihre Energie in einem sogenannten Streuvolumen. In diesem Streuvolumen erzeugen die Primärelektronen durch Ionisation Elektron-Loch-Paare. Befindet sich das Streuvolumen in hinreichend großem Abstand vom pn-Übergang der Halbleiterdiode, dann rekombinieren die Elektronen und Löcher wieder miteinander, nachdem sie im Mittel einer ihrer jeweiligen Diffusionslänge entsprechenden Weg zurückgelegt haben. Wandert der Primärelektronenstrahl über die Oberfläche der Halbleiterdiode hinweg und nähert sich dabei dem pn-Übergang, dann gelangen schließlich diffundierende Ladungsträger in den Einflußbereich des elektrischen Feldes der Raumladungszone des pn-Übergangs. Von diesem elektrischen Feld werden die jeweiligen Minoritätsträger auf die jeweils andere Seite des pn-Übergangs beschleunigt (Elektronen auf die n-Seite, Löcher auf die p-Seite). Bei geschlossenem äußeren Stromkreis ist ein "Ladungstrennungsstrom" (EBIC) vorhanden, der gemessen, verstärkt und beispielsweise zur Helligkeitsmodulation der Bildröhre des Raster-Elektronenmikroskops genutzt werden kann.

Zur Erzeugung eines solchen Ladungstrennungsstromes (EBIC) ist ein geschlossener Stromkreis erforderlich, der den zu lokalisierenden Leckstromkanal einschließt. Ein solcher geschlossener Stromkreis am Leckstrom ist jedoch im allgemeinen im Innern von integrierten Schaltungen nicht vorhanden.

Der vorliegenden Erfindung liegt die Aufgabe zugrunde, ein Verfahren und eine Vorrichtung der eingangs genannten Art anzugeben, mit deren Hilfe Leckstromkanäle im Innern von integrierten Schaltungen vollständig lokalisiert werden können.

Diese Aufgabe wird erfindungsgemäß durch ein Verfahren nach dem Anspruch 1 und durch eine Vorrichtung nach dem Anspruch 8 gelöst. Ausgestaltungen und Vorteile der Erfindung sind in den Unteransprüchen, der Beschreibung und der Zeichnung dargestellt.

Mit einem Verfahren nach der Erfindung können Leckstromkanäle im Innern von integrierten Schaltungen mit Hilfe eines Flüssigkristalles als Indikatorschicht und mit Hilfe einer bewegten, fokussierten Sonde als Stimulus für heiße Stellen dargestellt werden. Die bewegte, fokussierte Sonde kann eine Lasersonde sein, wie sie beispielsweise in der US-A 4 407 008 beschrieben ist. Die bewegte, fokussierte Sonde kann auch eine andere Lichtsonde sein.

Am Auftreffort der Sonde können lokal Elektron-Loch-Paare erzeugt werden. Dadurch wird wenigstens ein lokaler Strom hervorgerufen. Wenn der Auftreffort der Sonde ein beliebiger Schaltungsknoten ist, können in verschiedenen elektrischen Leitern auch verschiedene lokale Ströme erzeugt werden. Die lokalen Ströme rufen in den elektrischen Leitern, in denen sie fließen, eine Temperaturerhöhung hervor. Der Ort dieser Temperaturerhöhung wird lokal durch den Auftreffort der Sonde definiert. Je stärker ausgeprägt eine Schwachstelle innerhalb der integrierten Schaltung ist, desto weniger Elektron-Loch-Paare müssen in der näheren Umgebung dieser Schwachstelle erzeugt werden, damit die an dieser Schwachstelle hervorgerufene Temperaturerhöhung ausreicht, den die Oberfläche der integrierten Schaltung bedeckenden Flüssigkristall soweit zu erwärmen, daß über einen Phasenübergang (Strukturumwandlung) dieses Flüssigkristalles die Schwachstelle als solche nachgewiesen werden kann. Die Anzahl der erzeugten Elektron-Loch-Paare hängt von der Intensität der auf den Auftreffort auftreffenden Lichtstrahlung ab. Je geringer ausgeprägt eine Schwachstelle ist, desto größer muß die Intensität der auf den Auftreffort auftreffenden Lichtstrahlung sein, damit diese weniger stark ausgeprägte Schwachstelle über eine Phasenumwandlung des Flüssigkristalles als Schwachstelle nachgewiesen werden kann.

Die Wellenlänge der auf den Auftreffort auftreffenden Lichtstrahlung definieren die Eindringtiefe der Sonde. Durch Variation der Wellenlänge der Sonde kann ein Tiefenprofil im Innern der integrierten Schaltung bezüglich Schwachstellen aufgenommen werden.

Da ein Verfahren nach der Erfindung besonders vorteilhaft bei der Entwicklung von hochintegrierten Schaltungen angewendet werden kann, und da in diesem Entwicklungsstadium die zu untersuchenden hochintegrierten Schaltungen noch nicht mit einer Oxidschicht überzogen sind, genügen relativ geringe Teilchenenergien zur Erzeugung von Elektron-Loch- Paaren, z.B. genügt eine Teilchenenergie von 5 keV bei einer Elektronensonde.

Mit einem Verfahren und mit einer Vorrichtung nach der Erfindung können nicht nur heißeste Stellen, d.h. die am stärksten ausgeprägten Schwachstellen, im Innern einer integrierten Schaltung nachgewiesen werden, sondern durch Variation der Intensität der auftreffenden Lichtstrahlung und durch entsprechende Einstellung der Temperatur des Flüssigkristalles knapp unterhalb einer Strukturumwandlungs-Temperatur, bei der der Flüssigkristall seine optischen Eigenschaften ändert, auch solche Schwachstellen detektiert werden, die weniger stark ausgeprägt sind.

Bei einem Verfahren und bei einer Vorrichtung nach der Erfindung wird zur Detektion von Schwachstellen bzw. von Leckstromkanälen kein spezieller äußerer geschlossener Stromkreis wie z.B. bei EBIC benötigt.

Ausführungsbeispiele der Erfindung sind in der Zeichnung dargestellt und werden im folgenden näher erläutert.

Fig.1 zeigen Vorrichtungen nach der Erfindung. und 2

Fig.3 zeigt ein mit Hilfe der Erfindung erzieltes Ergebnis.

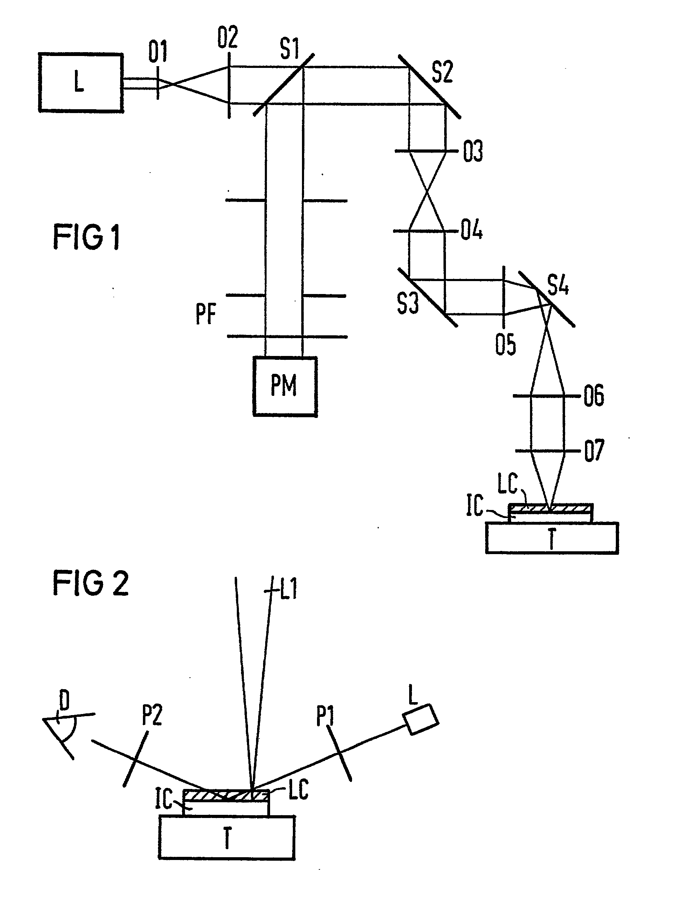

Fig.1 zeigt eine Vorrichtung nach der Erfindung. Wie bei der Flüssigkristall-Thermographie wird der zu untersuchende integrierte Schaltkreis IC mit einem Flüssigkristall LC bedeckt und auf einem Heiztisch T auf eine Temperatur aufgeheizt, die knapp unterhalb des Klärpunktes des Flüssigkristalles LC liegt. Unterhalb des Klärpunktes besitzt der Flüssigkeitkristall LC geordnete Bereiche, die nach Durchgang des an der Oberfläche des integrierten Schaltkreises IC reflektierten Lichtes durch das Polarisationsfilter PF und nach Verarbeitung dieses reflektierten Lichtes im Fotomultiplier PM in einem in der Fig.1 nicht dargestellten Bildschirm als leuchtend helle Bereiche erscheinen. Oberhalb des Klärpunktes besitzt der Flüssigkristall LC eine ungeordnete, amorphe Struktur. Nach Reflexion des Lichtes an der Oberfläche des integrierten Schaltkreises IC erscheinen solche ungeordneten Bereiche des Flüssigkristalles LC auf dem Bild hinter dem Polarisationsfilter PF und hinter dem Fotomultiplier PM dunkel.

Der integrierte Schaltkreis IC wird vorzugsweise an der oberen Grenze der Versorgungsspannung betrieben. Durch Bestrahlung mit dem Licht eines Lasers L in einem Laser-Raster-Mikroskop werden an diskreten, räumlich definierten Stellen durch Erzeugung von Elektron-Loch-Paaren am Auftreffort des Laser- Lichtes Ströme erzeugt, die einen räumlich punktuellen Temperaturanstieg an Schwachstellen innerhalb der elektrischen Schaltung in der näheren oder weiteren Umgebung des Auftreffortes der Lichtsstrahlung verursachen. Bei der Erzeugung von niedrigen Strömen können Schwachstellen nur in der näheren Umgebung des Auftreffortes des Laserlichtes nachgewiesen werden. Bei der Erzeugung von hohen Strömen infolge einer hohen Intensität des auftreffenden Laserlichtes können auch solche Schwachstellen nachgewiesen werden, die vom Auftreffort des Laserlichtes weiter entfernt sind, das bedeutet, daß die elektrische Verbindung zwischen Auftreffort und Schwachstelle dann auch länger sein kann.

Als Laser-Raster-Mikroskop kann beispielsweise ein Laser-Raster-Mikroskop verwendet werden, wie es in der US-Patentschrift 4407008 beschrieben ist. Das Licht des Lasers L wird
- mit Hilfe der Linse 01 fokussiert,
- mit Hilfe der Linse 02 kollimiert,
- am Spiegel S2 um 90° umgelenkt,
- mit Hilfe einer weiteren Linse 03 fokussiert und
- mit Hilfe einer weiteren Linse 04 wiederum kollimiert,
- an einem weiteren Spiegel S3 um einen variablen Winkel in der Umgebung von 90° abgelenkt,
- von einer weiteren Linse 05 wiederum fokussiert und
- gleichzeitig mit Hilfe eines weiteren Spiegels S4 um einen variablen Winkel in der Umgebung von 90° abgelenkt,
- mit Hilfe einer weiteren Linse 06 wiederum kollimiert und
- mit Hilfe einer letzten Linse 07 schließlich auf das Objekt fokussiert.

Das am Objekt reflektierte Licht durchläuft rückwärts zunächst denselben Strahlengang, wird sodann beim Rücklauf vor der Linse 02 von einem halbdurchlässigen Spiegel S1 um 90° umgelenkt und durchläuft sodann das Polarisationsfilter PF, um schließlich im Fotomultiplier PM weiterverarbeitet zu werden.

Die in ihrer räumlichen Anordnung variablen Spiegel S3 und S4 ermöglichen die Einstellung des fokussierten Lichtstrahles auf jeden gewünschten, diskreten Punkt auf der Oberfläche des integrierten Schaltkreises IC und somit auch ein Abrastern dieser Oberfläche des integrierten Schaltkreises IC.

Wenn das Laser-Raster-Mikroskop als Polarisationsmikroskop betrieben wird, wird der räumlich lokale Temperaturanstieg an einer Schwachstelle im Laser-Raster-Mikroskop als Umschlag des Flüssigkristalles LC in den amorphen, ungeordneten Zustand an diesem räumlich lokalen Punkt der Schwachstelle ("hot spot") registriert. Der Vorteil eines solchen Verfahrens ist, daß der hohe Strom, d.h. die hohe Temperatur, so verursacht werden kann, daß sie lokal begrenzt bleiben. Damit kann verhindert werden, daß eine solche Temperaturerhöhung, der eine nicht interessierende Ursache zugrunde liegt, zum Umschlagen des gesamten Flüssigkristalles LC von der geordneten Phase in die ungeordnete Phase führen würde. Eine solche nicht interessierende Ursache ist beispielsweise darin zu sehen, daß infolge einer Stromversorgung größerer Teile des integrierten Schaltkreises IC oder des gesamten Schaltkreises IC von außen her irgendwelche Bauelemente allmählich heiß werden, die für die Suche nach einer Schwachstelle in einem bestimmten Teil des integrierten Schaltkreises IC völlig ohne Interesse sind.

Elektronische Bauelemente können mit einem solchen Verfahren in jeder Betriebsart getestet werden. Ein spezieller äußerer Stromkreis zur Fehlererkennung ist bei einem solchen Verfahren nicht notwendig. Ein solches Verfahren ermöglicht das direkte Aufdecken von Schwachstellen, ohne daß bestimmte Prüfmuster an einen integrierten Schaltkreis IC angelegt werden müssen.

Durch langwellige Laser, beispielsweise im Infrarot-Bereich, die eine hohe Eindringtiefe aufweisen, können Schwachstellen bzw. Leckstromkanäle in größeren Tiefen des integrierten Schaltkreises IC sichtbar gemacht werden. Wenn ein durchstimmbarer Laser L verwendet wird oder wenn verschiedene Laser L mit verschiedenen Wellenlängen verwendet werden, können Tiefenprofile des integrierten Schaltkreises IC bezüglich Schwachstellen aufgenommen werden.

Fig.2 zeigt eine weitere Vorrichtung nach der Erfindung. Wiederum ist der zu testende integrierte Schaltkreis IC mit einem Flüssigkristall LC bedeckt und befindet sich auf einem Heiztisch T, dessen Temperatur knapp unterhalb des Klärpunktes des Flüssigkristalles LC aufgeheizt ist. Die Temperatur des Flüssigkristalles LC wird beispielsweise so eingestellt, daß sie etwa ¼ K unter derjenigen Temperatur ist, bei der der Flüssigkristall LC in seinen amorphen, nicht-kristallinen Zustand übergeht. Von einer Lichtquelle L aus wird durch einen ersten Polarisator P1 hindurch eine zu untersuchende Stelle auf der Oberfläche des integrierten Schaltkreises IC mit Licht bestrahlt. Dieses Licht wird an dem System Flüssigkristall LC/Oberfläche des integrierten Schaltkreises IC reflektiert. Dieses reflektierte Licht gelangt durch einen zweiten Polarisator P2 hindurch zu einem Detektor D, beispielsweise einem menschlichen Auge. Die Polarisatoren P1, P2 sind gekreuzt angeordnet. Wird als Flüssigkristall beispielsweise MBBA (N-(p-Methoxy-benzyliden)-p-n-butylanilin) verwendet, sind die beiden gekreuzten Polarisatoren P1, P2 bei Winkelstellungen von 45° zueinander angeordnet, so erscheint ein kristalliner Bereich des Flüssigkristalles LC beim Detektor D hell. Ist aufgrund einer Temperaturerhöhung ein räumlicher Bereich des Flüssigkristalles LC in den amorphen Zustand übergegangen, so wird das polarisierte Licht in diesem amorphen Bereich gestreut, und der sonst klare Flüs sigkristall LC erscheint in der Reflexion beim Detektor D dunkel. Der Temperaturanstieg in einem räumlich begrenzten Bereich, beispielsweise einer Schwachstelle im Innern einer integrierten Schaltung, wird dabei durch Bestrahlung einer räumlich lokal definierten Stelle mit Hilfe eines zweiten Lichtstrahls L1 hervorgerufen. Am Auftreffort des zweiten Lichtstrahls L1 werden dabei durch Erzeugung von Elektron-Loch-Paaren mehr oder weniger hohe Ströme hervorgerufen, die einen räumlich lokalen Temperaturanstieg an Schwachstellen des integrierten Schaltkreises IC verursachen. Diese Vorrichtung bietet den Vorteil, daß auch andere Stellen im Innern einer elektrischen Schaltung angesehen werden können als nur diejenige Stelle, die mit dem zweiten Lichtstrahl L1 aufgeheizt wird. Dadurch können auch andere Stellen als Schwachstellen detektiert werden als nur diejenige Stelle, die mit dem zweiten Lichtstrahl 1 aufgeheizt wird.

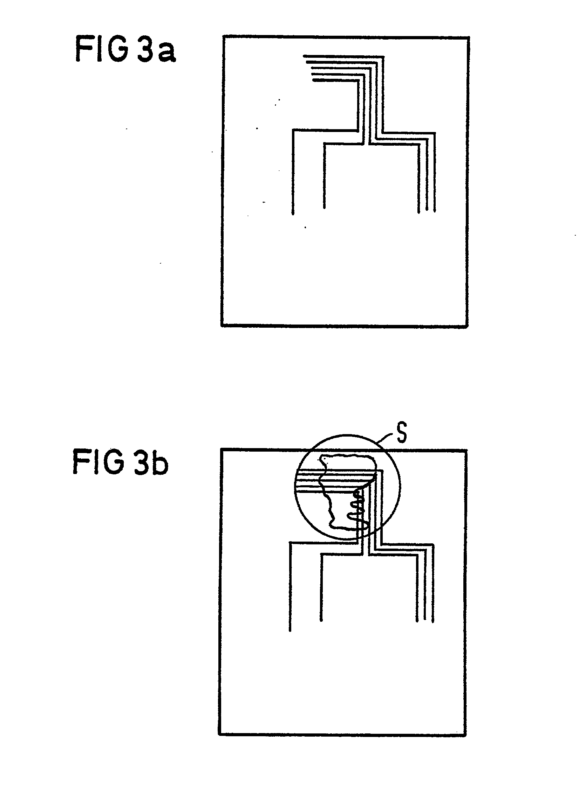

Fig.3 zeigt das Ergebnis einer Messung mit einem Verfahren und einer Vorrichtung nach der Erfindung. Bild A zeigt eine Raster- Abbildung der Oberfläche eines integrierten Schaltkreises IC mit Hilfe eines Laser-Raster-Mikroskops. Dabei wird das Laser -Raster-Mikroskop als Polarisationsmikroskop betrieben und rastert dabei sukzessive die gesamte Oberfläche oder einen Teil der Oberfläche des integrierten Schaltkreises IC ab.

Bild B zeigt den gleichen Bildausschnitt wie Bild A. Vor Erzeugung des Bildes B wurden mit Hilfe einer Lasersonde jedoch im Bereich des "hot spot" S relativ hohe Ströme erzeugt. Diese hohen Ströme haben beim Durchfließen einer Schwachstelle ("hot spot" S) eine Erwärmung und damit ein Umschlagen des Flüssigkristalles LC in seinen amorphen Zustand bewirkt. Zur Erzeugung einer Lasersonde kann ein Laser-Raster-Mikroskop als Lasersonde betrieben werden. Es ist jedoch auch denkbar, daß ein zusätzlicher Laser das zur Erzeugung der Elektron- Loch-Paare erforderliche Licht liefert.

**Patentansprüche**

1. Verfahren zur Lokalisierung von Schwachstellen (S) im Innern einer elektrischen integrierten Schaltung (IC), bei dem die zu testende elektrische Schaltung (IC) mit einem Flüssigkristall (LC) bedeckt und auf eine Temperatur knapp unterhalb des Klärpunktes des Flüssigkristalles (LC) aufgeheizt wird, und bei dem bei einem Temperaturanstieg der Flüssigkristall (LC) in den ungeordneten Zustand übergeht, dadurch **gekennzeichnet,** daß durch Bestrahlung eines räumlichen Bereiches an diesem räumlichen Bereich durch Erzeugung von Elektron-Loch-Paaren im Innern der elektrischen integrierten Schaltung (IC) wenigstens ein Strom hervorgerufen wird, der einen Temperaturanstieg an wenigstens einer Schwachstelle (S) der elektrischen integrierten Schaltung (IC) verursacht.

2. Verfahren nach Anspruch 1, dadurch **gekennzeichnet,** daß der Temperaturanstieg in einem Laser- Raster-Mikroskop beobachtet wird.

3. Verfahren nach Anspruch 1 oder 2, dadurch **gekennzeichnet,** daß die Bestrahlung mit Laserlicht in einem Laser-Raster-Mikroskop erfolgt.

4. Verfahren nach Anspruch 1 oder 2, dadurch **gekennzeichnet,** daß die Bestrahlung mit einem zweiten Lichtstrahl (L1) erfolgt.

5. Verfahren nach einem der Ansprüche 1 bis 4, dadurch **gekennzeichnet,** daß die elektrische integrierten Schaltung (IC) an der oberen Grenze der Versorgungsspannung betrieben wird.

6. Verfahren nach einem der Ansprüche 1 bis 5, dadurch **gekennzeichnet,** daß die Wellenlänge der Bestrahlung variiert wird und daß dadurch Schwachstellen (S) in verschiedenen Tiefen nachgewiesen werden.

7. Verfahren nach Anspruch 6, dadurch **gekennzeichnet,** daß ein Tiefenprofil bezüglich Schwachstellen (S) aufgenommen wird.

8. Vorrichtung zur Lokalisierung von Schwachstellen (S) im Innern einer elektrischen integrierten Schaltung (IC), mit einer Einrichtung (T) zum Heizen der elektrischen integrierten Schaltung (IC), mit einem Flüssigkristall (LC) auf der Oberfläche der elektrischen integrierten Schaltung (IC), wobei der Flüssigkristall durch die Einrichtung zum Heizen auf eine Temperatur knapp unterhalb seiner Klärtemperatur aufgeheizt wird und mit Mitteln zur Beobachtung des Flüssigkristalls **gekennzeichnet** durch eine Einrichtung (L) zur Bestrahlung eines räumlichen Bereiches im Innern der elektrischen integrierten Schaltung (IC) und zur Erzeugung von Elektron-Loch-Paaren in diesem räumlichen Bereich.

9. Vorrichtung nach Anspruch 8, **gekennzeichnet** durch ein Laser-Raster-Mikroskop zur Abbildung des räumlichen Bereiches im Innern der elektrischen integrierten Schaltung (IC).

10. Vorrichtung nach Anspruch 8 oder 9, **gekennzeichnet** durch einen Laser (L) zur Erzeugung von Elektron-Loch-Paaren in diesem räumlichen Bereich im Innern der elektrischen integrierten Schaltung (IC).

11. Vorrichtung nach Anspruch 10, **gekennzeichnet** durch einen Laser (L) mit variabler Lichtwellenlänge.

12. Vorrichtung nach Anspruch 8 oder 9, **gekennzeichnet** durch einen zweiten Lichtstrahl (L1) zur Erzeugung von Elektron-Loch-Paaren in diesem räumlichen Bereich im Innern der elektrischen integrierten Schaltung (IC).

## Claims

1. Method for determining the weak points (S) within an electrical integrated circuit (IC), in which the electrical circuit (IC) to be tested is covered with a liquid crystal (LC), and heated to a temperature just below the clear point of the liquid crystal (LC), and in which the liquid crystal (LC) passes over into the disordered state when there is a temperature rise, characterised in that by irradiating a spatial domain there is created in this domain by virture of the generation of electron-hole pairs within the electrical integrated circuit (IC) at least one current, which causes a temperature rise at at least one weak point (S) of the electrical integrated circuit (IC).

2. Method according to Claim 1, characterised in that the temperature rise is observed in a scanning laser microscope.

3. Method according to Claim 1 or 2, characterised in that the irradiation takes place by laser light in a scanning laser microscope.

4. Method according to Claim 1 or 2, characterised in that the irradiation takes place with a second light beam (L1).

5. Method according to one of Claims 1 to 4, characterised in that the electrical integrated circuit (IC) is operated at the upper limit of the supply voltage.

6. Method according to one of Claims 1 to 5, characterised in that the wavelength of the irradiation is varied, and in that weak points (S) are thereby detected at different depths.

7. Method according to Claim 6, characterised in that a depth profile relating to weak points (S) is recorded.

8. Arrangement for determining the weak points (S) within an electrical integrated circuit (IC), having a device (T) for heating the electrical integrated circuit (IC), a liquid crystal (LC) on the surface of the electrical integrated circuit (IC), the liquid crystal being heated by the device for heating to a temperature just below its clear point, and means for observing the liquid crystal, characterised by a device (L) for irradiating a spatial domain within the electrical integrated circuit (IC) and for generating electron-hole pairs in this spatial domain.

9. Arrangement according to Claim 8, characterised by a scanning laser microscope for imaging the spatial domain within the electrical integrated circuit (IC).

10. Arrangement according to Claim 8 or 9, characterised by a laser (L) for generating electron-hole pairs in this spatial domain within the electrical integrated circuit (IC).

11. Arrangement according to Claim 10, characterised by a laser (L) with variable optical wavelength.

12. Arrangement according to Claim 8 or 9, characterised by a second light beam (L1) for generating electron-hole pairs in this spatial domain within the electrical integrated circuit (IC).

## Revendications

1. Procédé pour localiser des points faibles (S) à l'intérieur d'un circuit électrique intégré (IC), selon lequel on recouvre le circuit électrique (IC) à contrôler, avec un cristal liquide (LC) et on le chauffe à une température située juste au-dessous de la température de clarification du cristal liquide (LC), et selon lequel, lors d'un accroissement de la température, le cristal liquide (LC) passe dans l'état désordonné, caractérisé en ce qu'à l'aide d'une irradiation d'une zone spatiale, on fait apparaître, dans cette zone spatiale, par suite de la production de couples électron-trou à l'intérieur du circuit électrique intégré (IC), au moins un courant qui provoque un accroissement de la température d'au moins un point faible (S) du circuit intégré électrique (IC).

2. Procédé suivant la revendication 1, caractérisé par le fait qu'on observe l'accroissement de la température dans un microscope à balayage à laser.

3. Procédé suivant la revendication 1 ou 2, caractérisé par le fait que l'irradiation est effectuée avec une lumière laser dans un microscope à balayage à laser.

4. Procédé suivant la revendications 1 ou 2, caractérisé par le fait que l'irradiation est réalisée à l'aide d'un second faisceau de lumière (L1).

5. Procédé suivant l'une des revendications 1 à 4, caractérisé par le fait qu'on fait fonctionner le circuit électrique intégré (IC) en utilisant la limite supérieure de la tension d'alimentation.

6. Procédé suivant l'une des revendications 1 à 5, caractérisé par le fait qu'on modifie la longueur d'onde d'irradiation et qu'on détecte, de ce fait, des points faibles (S) à différentes profondeurs.

7. Procédé suivant la revendication 6, caractérisé par le fait qu'on enregistre un profil de profondeur, en rapport avec les points faibles (S).

8. Dispositif pour localiser des points faibles (S) à l'intérieur d'un circuit électrique intégré (IC), comportant un dispositif (T) servant à chauffer le circuit électrique intégré (IC), un cristal liquide (LC) situé sur la surface du circuit électrique intégré (IC), ce cristal étant chauffé par le dispositif de chauffage à une température juste inférieure à sa température de clarification, et des moyens servant à observer le cristal liquide, caractérisé par un dispositif (L) servant à irradier une zone spatiale située à l'intérieur du circuit électrique intégré (IC) et à produire des couples électron-trou dans cette zone spatiale.

9. Dispositif suivant la revendication 8, caractérisé par un microscope à balayage à laser servant à former l'image de la zone spatiale présente à l'intérieur du circuit électrique intégré (IC).

10. Dispositif suivant la revendication 8 ou 9, caractérisé par un laser (L) servant à produire des couples électron-trou dans cette zone spatiale située à l'intérieur du circuit électrique intégré (IC).

11. Dispositif suivant la revendication 10, caractérisé par un laser (L) possédant une longueur d'onde lumineuse variable.

12. Dispositif suivant la revendication 8 ou 9, caractérisé par un second faisceau de lumière (L1) servant à produire des couples électron-trou dans cette zone spatiale située à l'intérieur du circuit électrique intégré (IC).

EP 0 177 722 B1

FIG 1

FIG 2

FIG 3a

FIG 3b